# EUROPEAN PATENT APPLICATION

(11) **EP 4 676 179 A1**
(43) Date of publication of application: **07.01.2026**
(21) Application number: 25183577.3
(22) Date of filing: 18.06.2025
(51) Int. Cl.: H10B 12/00

(54) **SEMICONDUCTOR DEVICES**

(30) Priority: 03.07.2024 KR 20240087268
(71) Applicant: Samsung Electronics Co., Ltd., Suwon-si, Gyeonggi-do 16677 (KR)
(72) Inventor: KIM, Jaeho, 16677 Suwon-si, Gyeonggi-do (KR); KIM, Bitna, 16677 Suwon-si, Gyeonggi-do (KR); JANG, Sunghwan, 16677 Suwon-si, Gyeonggi-do (KR); YANG, Guifu, 16677 Suwon-si, Gyeonggi-do (KR); JUNG, Soonwook, 16677 Suwon-si, Gyeonggi-do (KR)
(74) Representative: Kuhnen & Wacker Patent- und Rechtsanwaltsbüro PartG mbB

(57) **Abstract**

A semiconductor device includes an active pattern (110) extending in a first horizontal direction (X) and including a first source/drain region (SD1), a second source/drain region (SD2) and a channel region (CH) between the first and second source/drain regions (SD1, SD2), the first source/drain region (SD1) including a first region (R1) and a second region (R2) between the channel region (CH) and the first region (R1), a metal-semiconductor compound layer (120) on the first region (R1) of the first source/drain region (SD1) of the active pattern (110), a bit line (160) extending in a vertical direction (Z) and contacting the active pattern (110), and a gate electrode (142) vertically overlapping at least a portion of the channel region (CH) of the active pattern (110) and extending in a second horizontal direction (Y), the second horizontal direction (Y) intersecting the first horizontal direction (X), wherein a length of the first region (R1) in the first horizontal direction (X) is greater than a length of the second region (R2) in the first horizontal direction (X).

## Description

### BACKGROUND

The present inventive concepts relate to semiconductor devices.

As demand for higher performance, higher speed, and/or multifunctionality of semiconductor devices increases, the integration of semiconductor devices is increasing. In manufacturing semiconductor devices with fine patterns corresponding to the trend for higher integration of semiconductor devices, implementing patterns having finer widths or finer spacings is required.

### SUMMARY

Some example embodiments provide semiconductor devices including a metal-semiconductor compound layer covering a source/drain region of an active pattern.

According to an example embodiment, a semiconductor device includes an active pattern extending in a first horizontal direction, the active pattern including a first source/drain region, a second source/drain region and a channel region between the first and second source/drain regions, the first source/drain region including a first region and a second region, the second region being between the channel region and the first region, a metal-semiconductor compound layer on the first region of the first source/drain region of the active pattern, a bit line extending in a vertical direction and contacting the active pattern, and a gate electrode vertically overlapping at least a portion of the channel region of the active pattern, the gate electrode extending in a second horizontal direction, the second horizontal direction intersecting the first horizontal direction, wherein a first length of the first region in the first horizontal direction is greater than a second length of the second region in the first horizontal direction.

According to an example embodiment, a semiconductor device includes an active pattern extending in a first horizontal direction and including a first source/drain region, a second source/drain region and a channel region between the first and second source/drain regions, the first source/drain region including a first region and a second region, the second region being between the channel region and the first region, a bit line extending in a vertical direction and contacting the active pattern, a gate electrode vertically overlapping at least a portion of the channel region of the active pattern, the gate electrode extending in a second horizontal direction, the second horizontal direction intersecting the first horizontal direction, an insulating layer covering the gate electrode and upper and lower portions of the second region of the first source/drain region of the active pattern, and a metal-semiconductor compound layer on a side surface of the insulating layer and surrounding the first region of the first source/drain region of the active pattern.

According to an example embodiment, a semiconductor device includes active patterns extending in a first horizontal direction, the active patterns stacked while being spaced apart from each other in a vertical direction, each of the active patterns including a first source/drain region, a second source/drain region and a channel region between the first and second source/drain regions, the first source/drain region including a first region and a second region, the second region being between the channel region and the first region, a bit line extending in the vertical direction and contacting the second source/drain region of the active patterns, cell gate electrodes each vertically overlapping at least a portion of the channel region of a corresponding one of the active patterns, the cell gate electrodes extending in a second horizontal direction, the second horizontal direction intersecting the first horizontal direction, a first insulating layer between the active patterns, the first insulating layer covering the gate electrode and upper and lower portions of the second region of the first source/drain region of the active pattern, a metal-semiconductor compound layer on a side surface of the first insulating layer, the metal-semiconductor compound layer surrounding the first region of the first source/drain region of the active pattern, a second insulating layer on the side surface of the first insulating layer, the second insulating layer covering at least a portion of the metal-semiconductor compound layer, and a capacitor structure in contact with at least a portion of the metal-semiconductor compound layer.

### BRIEF DESCRIPTION OF DRAWINGS

The above and other aspects, features, and advantages of the present inventive concepts will be more clearly understood from the following detailed description, taken in conjunction with the accompanying drawings, in which:
FIG. 1 is a conceptual perspective view of a semiconductor device according to an example embodiment;
FIG. 2 is a circuit diagram of a memory cell in a memory cell area according to an example embodiment;
FIG. 3 is a vertical cross-sectional view along line I-I' of the memory cell area illustrated in FIG. 1;
FIG. 4A is an enlarged view of a portion of the semiconductor device illustrated in FIG. 3;
FIGS. 4B and 4C are enlarged views of a portion of a semiconductor device according to an example embodiment;
FIGS. 5A and 5B are enlarged views of a portion of a semiconductor device according to an example embodiment;
FIGS. 6 to 16 are vertical cross-sectional views illustrating various process steps of a method of manufacturing a semiconductor device according to an example embodiment; and
FIGS. 17 and 18 are vertical cross-sectional views illustrating various process steps of a method of manufacturing a semiconductor device according to an example embodiment.

### DETAILED DESCRIPTION

Hereinafter, some example embodiments will be described with reference to the accompanying drawings.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

As used herein, expressions such as "one of," "any one of," and "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

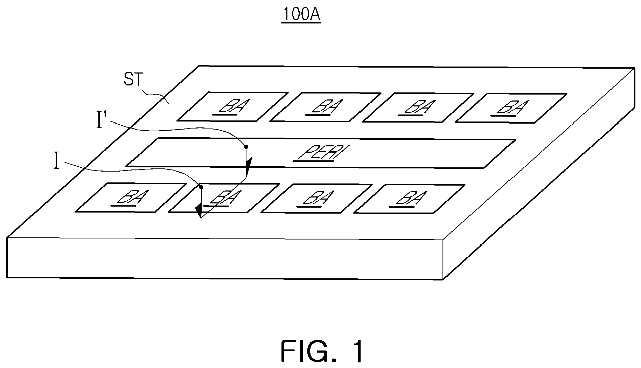

FIG. 1 is a conceptual perspective view of a semiconductor device according to an example embodiment.

Referring to FIG. 1, a semiconductor device 100A according to an example embodiment may include a chip structure ST including memory cells MC. According to an example embodiment, the semiconductor device 100A may further include another chip structure disposed on the chip structure ST and vertically overlapping the chip structure ST. In this case, the chip structures may be formed by bonding by a bonding process such as a wafer bonding process.

The semiconductor device 100A may include a plurality of banks BA and a peripheral circuit area PERI. The peripheral circuit area PERI may be a peripheral circuit area in which peripheral circuits for input/output of data or commands and/or input of power/ground are disposed. The plurality of banks BA may include a memory cell area.

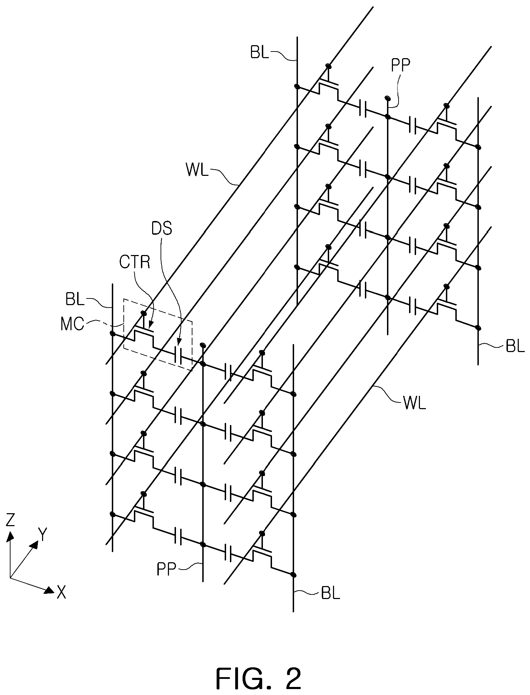

FIG. 2 is a circuit diagram of a memory cell of a memory cell area according to an example embodiment.

Referring to FIG. 2, the memory cell area may include memory cells MC arranged along the X-direction (which may be an example of a first horizontal direction) and the Y-direction (which may be an example of a second horizontal direction), word lines WL connected to the memory cells MC and extending in the Y-direction, and bit lines BL connected to the memory cells MC and extending in the vertical direction.

Each of the memory cells MC may include a cell transistor CTR and an information storage structure DS that may perform an information storage function. In a memory such as a DRAM, the information storage structure DS may be a cell capacitor that may store information. Adjacent information storage structures DS may share a plate electrode PP. For example, the plate electrode PP may extend in the vertical direction and be electrically connected to the information storage structures DS.

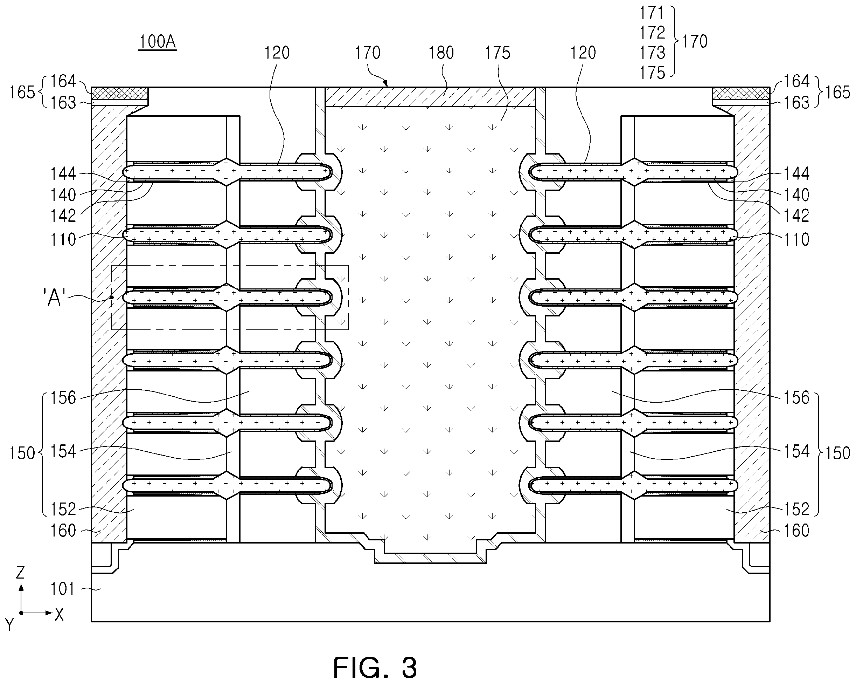

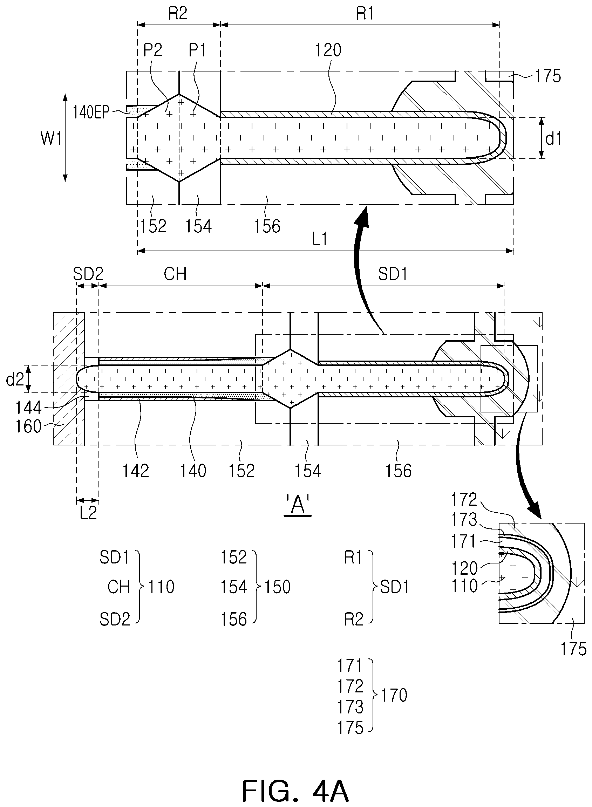

FIG. 3 is a vertical cross-sectional view of the semiconductor device illustrated in FIG. 1, taken along line I-I'. FIG. 4A is a partially enlarged view of the region 'A' of the semiconductor device illustrated in FIG. 3.

Referring to FIG. 3 and FIG. 4A, the semiconductor device 100A may refer to the memory cell area. The semiconductor device100A may include a substrate 101, and an active pattern 110, a metal-semiconductor compound layer 120, a gate electrode 142, a bit line 160, and a capacitor structure 170 on the substrate 101.

The active pattern 110 is arranged on the substrate 101 and may extend horizontally in the X-direction. The active patterns 110 may be arranged to be spaced apart from each other in the Y-direction and the vertical direction. In one example, the active pattern 110 may include a semiconductor material, for example, silicon, germanium, or silicon-germanium.

Each of the active patterns 110 may include first and second source/drain regions SD1 and SD2 and a channel region CH. Each of the first and second source/drain regions SD1, SD2 may be referred to as first and second impurity regions. The first source/drain region SD1 and the second source/drain region SD2 may be arranged at opposite ends of the active pattern 110 in the X-direction, and the channel region CH may be arranged between the first source/drain region SD1 and the second source/drain region SD2.

The first source/drain region SD1 may include a first region R1 and a second region R2. The first region R1 may be a region adjacent to the capacitor structure 170, and the second region R2 may be a region adjacent to the bit line 160. The first region R1 and the second region R2 may be adjacent to each other.

The first region R1 may be surrounded by a metal-semiconductor compound layer 120. The metal-semiconductor compound layer 120 contacts the first electrode 171 of the capacitor structure 170, and thus, the first region R1 may be electrically connected to the first electrode 171 by the metal-semiconductor compound layer 120.

The first region R1 may have a first thickness d1 in a vertical direction. The first thickness d1 may be defined as a maximum thickness of the first region R1 in a vertical direction. The first thickness d1 may have, for example, a thickness of about 10 nm or more. According to an example embodiment, the first thickness d1 may have a range of about 10 nm or more and about 15 nm or less.

The second region R2 may include a first portion P1 and a second portion P2. The first portion P1 may be defined as a portion adjacent to the first region R1, and the second portion P2 may be defined as a portion adjacent to the channel region CH. The thickness of the first portion P1 in the vertical direction may increase, the farther the first portion P1 is from the first region R1 and the closer the first portion P1 is to the second portion P2. The thickness of the second portion P2 in the vertical direction may increase, the farther the second portion P2 is from the channel region CH and the second portion P2 is closer to the first portion P1. A length of the first region R1 in the X-direction may be greater than a length of the second region R2 in the X-direction.

The maximum thickness W1 of the second region R2 in the vertical direction may be greater than the first thickness d1 of the first region R1. The maximum thickness W1 may have, for example, a thickness of about 10 nm or more. According to an example embodiment, the maximum thickness W1 may have a range of about 10 nm or more and about 20 nm or less. According to an example embodiment, the maximum thickness W1 may have a range of about 10 nm or more and about 15 nm or less. According to an example embodiment, the maximum thickness W1 may be referred to as a first maximum thickness. The first part P1 and the second part P2 are conveniently separated to explain the shape of the second region R2, and in reality, the boundary between the first part P1 and the second part P2 may not be separated or distinguished.

The first region R1 and the second region R2 may be continuous. For example, at the boundary between the first and second regions R1, R2, the sizes of the cross-sectional area of the first region R1 along the Y-direction and the cross-sectional area of the second region R2 along the Y-direction may be substantially the same. The upper surface of the first region R1 may be continuously connected to the upper surface of the second region R2.

The second source/drain region SD2 may be in contact with the bit line 160 and may be electrically connected to the bit line 160. The second source/drain region SD2 may have a second thickness d2 in a vertical direction. The second thickness d2 may be defined as a maximum thickness of the second source/drain region SD2 in the vertical direction. The second thickness d2 may have a thickness of, for example, about 5 nm or more. According to one embodiment, the second thickness d2 may have a range of about 5 nm or more and about 10 nm or less. According to one embodiment, the second thickness d2 may be referred to as a second maximum thickness. The first maximum thickness of the second region R2 may be greater than a second maximum thickness of the second source/drain region SD2.

A length L1 of the first source/drain region SD1 in the X-direction and a length L2 of the second source/drain region SD2 in the X-direction may be different from each other. In an example embodiment, the length L1 of the first source/drain region SD1 in the X-direction may be greater than the length L2 of the second source/drain region SD2 in the X-direction.

The channel region CH may overlap the gate electrodes 142 in the vertical direction. When the active pattern 110 is formed of or includes a semiconductor material, the first source/drain region SD1 and the second source/drain region SD2 may each include impurities, and the impurities may have an n-type or p-type conductivity. In the present example embodiment, the first and second source/drain regions SD1 and SD2 may have an n-type conductivity type.

A portion of the active pattern 110 that vertically overlaps the gate electrode 142 and the gate electrode 142 may form the cell transistor CTR of FIG. 2. At least a portion of the first source/drain region SD1 may correspond to the first source/drain region of the cell transistor CTR of FIG. 2, and at least a portion of the second source/drain region SD2 may correspond to the second source/drain region of the cell transistor CTR of FIG. 2A. At least a portion of the channel region CH may correspond to the channel of the cell transistor CTR of FIG. 2A. The first source/drain region SD1 may provide a region for directly connecting the cell transistor CTR to the information storage structure DS, and the second source/drain region SD2 may provide a region for directly connecting the cell transistor CTR to the bit line BL.

The metal-semiconductor compound layer 120 may surround the first region R1 of the first source/drain region SD1.

The upper surface and the lower surface of the first region R1 of the first source/drain region SD1 may be covered by a third insulating pattern 156. The metal-semiconductor compound layer 120 may conformally cover the upper surface, the side surface, and the lower surface of the first region R1 of the first source/drain region SD1 on the side surface of the second insulating pattern 154.

The metal-semiconductor compound layer 120 and the second region R2 of the first source/drain region SD1 may be discontinuous. For example, with respect to the side surface of the second insulating pattern 154, the upper surface of the metal-semiconductor compound layer 120 and the upper surface of the second region R2 may be misaligned. In other words, the upper surface of the metal-semiconductor compound layer 120 may not be continuously connected to the upper surface of the second region R2.

The metal-semiconductor compound layer 120 may include a metal-semiconductor compound, for example, molybdenum silicide (MoSi), cobalt silicide (CoSi), titanium silicide (TiSi), nickel silicide (NiSi), tungsten silicide (WSi), or other metal silicides. The metal-semiconductor compound layer 120 may include at least one of the above metal-semiconductor compounds.

The gate electrodes 142 are arranged on the substrate 101 and may extend horizontally in the Y-direction. The gate electrodes 142 may be arranged to be spaced apart from each other in the X-direction and the vertical direction. The gate electrodes 142 may be vertically overlapped with the channel regions CH of the active pattern 110. The gate electrodes 142 may include a conductive material, and the conductive material may include at least one of a doped semiconductor material for example, doped silicon, doped germanium, or the like, conductive metal nitride for example, titanium nitride, tantalum nitride, tungsten nitride, or the like, metal for example, tungsten, titanium, tantalum, cobalt, aluminum, ruthenium, or the like, or a metal-semiconductor compound for example, tungsten silicide, cobalt silicide, titanium silicide, or the like. At least one of the gate electrodes 142 may correspond to the word lines WL described with reference to FIG. 2.

The gate electrodes 142 may be arranged on the upper and lower surfaces of each active pattern 110, and two gate electrodes 142 adjacent to each active pattern 110 may constitute one word line WL.

The semiconductor device 100A may further include a gate dielectric layer 140 and a gate capping layer 144.

The gate dielectric layer 140 may be arranged between the active pattern 110 and the gate electrode 142. For example, the gate dielectric layer 140 may be arranged between the channel region CH and the gate electrode 142.

In an example embodiment, at least a portion of the gate dielectric layer 140 may extend to the second region R2 of the first source/drain region SD1. For example, the end 140EP of the gate dielectric layer 140 may be arranged on the side surface of the second region R2 of the first source/drain region SD1.

In an example embodiment, the thickness of the gate dielectric layer 140 in the vertical direction may vary along the X-direction. For example, the thickness of the gate dielectric layer 140 on the side surface of the second region R2 of the first source/drain region SD1 may be thicker than the thickness of the gate dielectric layer 140 on the channel region CH. Accordingly, the thickness of the gate electrode 142 in the vertical direction may also vary along the X-direction. For example, the thickness of the gate electrode 142 adjacent to the second region R2 of the first source/drain region SD1 may be thinner than the thickness of the gate electrode 142 adjacent to the second source/drain region SD2.

The gate dielectric layer 140 may include at least one of silicon oxide, silicon nitride, a low-x material, or a high-κ material. The high-κ material may mean a dielectric material having a higher dielectric constant than silicon oxide, and the low-κ material may mean a dielectric material having a lower dielectric constant than silicon oxide. The high-κ material may be, for example, metal oxide or metal oxynitride. The high-κ material may be, for example, one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSixOy), hafnium oxide (HfO₂), hafnium silicon oxide (HfSixOy), lanthanum oxide (La₂O₃), lanthanum aluminum oxide (LaAlxOy), lanthanum hafnium oxide (LaHfxOy), hafnium aluminum oxide (HfAlxOy), or praseodymium oxide (Pr₂O₃). The gate dielectric layer 140 may be formed as a single layer or multiple layers of the above-described materials.

The gate capping layer 144 may be disposed between the gate electrode 142 and the bit line 160. The gate capping layers 144 may include an insulating material, for example, at least one of silicon nitride, silicon oxynitride, or silicon oxycarbide.

The bit lines 160 may extend in the X-direction and the vertical direction on the substrate 101. The bit lines 160 may be arranged to be spaced apart from each other in the X-direction and the Y-direction. A plurality of active patterns 110 stacked in the vertical direction may be electrically connected to one bit line 160. For example, the bit line 160 may be electrically connected to the second source/drain regions SD2 of the active patterns 110. The bit lines 160 may include at least one of a doped semiconductor material, conductive metal nitride, metal, or a metal-semiconductor compound. For example, the bit lines 160 may include doped polysilicon. The bit lines 160 may correspond to the bit lines BL described with reference to FIG. 2.

The semiconductor device 100A may further include a contact structure 165 on the bit lines 160. The contact structure 165 may include a first conductive layer 163 and a second conductive layer 164. The first conductive layer 163 may be in contact with the upper surface of the bit lines 160, and the second conductive layer 164 may be disposed on the first conductive layer 163.

The first conductive layer 163 may include a metal-semiconductor compound. The metal-semiconductor compound may be, for example, a layer that silicides a portion of the bit lines 160. For example, the metal-semiconductor compound may include cobalt silicide (CoSi), titanium silicide (TiSi), nickel silicide (NiSi), tungsten silicide (WSi), or other metal silicides, or may include nitrides such as TiSiN. The second conductive layer 164 may include metal materials such as titanium (Ti), tantalum (Ta), tungsten (W), and aluminum (Al).

The semiconductor device 100A may further include insulating structures 150. In the cross-sectional view, the insulating structures 150 may be arranged between the active patterns 110 and may be spaced apart in the Y-direction. Although not illustrated, the insulating structures 150 may be alternately arranged along the bit lines 160 and the Y-direction, and thus, the insulating structures 150 may spatially separate the bit lines 160 from each other and electrically insulate the same.

The insulating structures 150 may each include a first insulating pattern 152, a second insulating pattern 154, and a third insulating pattern 156. Each of the first, second, and third insulating patterns may be referred to as a first, second, and third insulating layer 152, 154 and 156.

The first insulating pattern 152 may be in contact with the gate dielectric layer 140, the gate electrode 142, the gate capping layer 144, and the bit line 160. The first insulating pattern 152 may be in contact with at least a portion of the first source/drain region SD1. The first insulating pattern 152 may, for example, contact the upper surface and the lower surface of the second portion P2 of the second region R2.

The second insulating pattern 154 may contact at least a portion of the first source drain SD1 and may be on the side surface of the first insulating pattern 152. The second insulating pattern 154 may, for example, surround the upper surface and the lower surface of the first portion P1 of the second region R2 and on the side surface of the first insulating pattern 152.

The third insulating pattern 156 may cover the first source/drain region SD1 on the side surface of the second insulating pattern 154. The third insulating pattern 156 may, for example, cover at least a portion of the metal-semiconductor compound layer 120 and may be on the side surface of the second insulating pattern 154.

The capacitor structure 170 may be in contact with the active patterns 110 and may be electrically connected to the active patterns 110. The capacitor structure 170 may include first electrodes 171, a second electrode 172 on the first electrodes 171, a plate electrode 175 on the second electrode 172, and a capacitor dielectric 173 between the first electrodes 171 and the second electrode 172. The first electrodes 171 may each be in contact with an end of the metal-semiconductor compound layer 120. Accordingly, the first source/drain region SD1 may be electrically connected to the capacitor structure 170 by the metal-semiconductor compound layer 120. The first electrodes 171 may have a cylinder shape, but are not limited thereto, and in some example embodiments, may have a pillar shape.

The first electrodes 171 may be in a node-separated state between the active patterns 110. For example, the first electrodes 171 may be arranged spaced apart from each other. The first electrodes 171 may be referred to as 'storage node electrodes.' The first electrodes 171 may include at least one of a doped semiconductor material, conductive metal nitride, metal, or a metal-semiconductor compound.

The second electrode 172 may cover the first electrodes 171 and extend in a vertical direction, and may cover the upper surface of the substrate 101. The capacitor dielectric 173 may extend between the first electrodes 171 and the second electrode 172. The capacitor dielectric 173 may cover the upper surface of the substrate 101 and electrically insulate the substrate 101 and the capacitor structure 170 from each other. In an example embodiment, the substrate 101 may include an impurity region in a region in contact with the second electrode 172. The capacitor structure 170 may not be electrically connected to the substrate 101 due to the impurity region. The second electrode 172 and portions of the capacitor dielectric 173 and the first electrode 171 may correspond to the information storage structure DS illustrated in FIG. 2. The plate electrode 175 may correspond to the plate electrode PP.

The second electrode 172 may include at least one of a doped semiconductor material, conductive metal nitride, metal, or a metal-semiconductor compound. In an example embodiment, the first electrode 171 and the second electrode 172 may include titanium nitride. The capacitor dielectric 173 may include at least one of a high-κ material such as zirconium oxide (ZrO₂), aluminum oxide (Al₂O₃), and hafnium oxide (Hf₂O₃), for example.

The plate electrode 175 may cover the second electrode 172 and extend in a vertical direction. The plate electrode 175 may include at least one of a doped semiconductor material, conductive metal nitride, metal, or a metal-semiconductor compound. In an example embodiment, the plate electrode 175 may include silicon-germanium.

The contact plug 180 may be disposed on the plate electrode 175. The contact plug 180 may be electrically connected to the information storage structures DS through the plate electrode 175. The contact plug 180 may include at least one of a doped semiconductor material, conductive metal nitride, metal, or a metal-semiconductor compound.

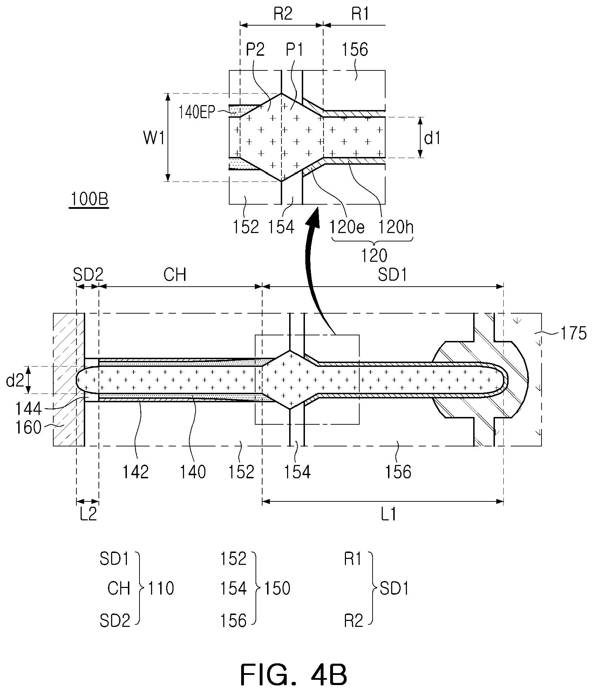

FIG. 4B is an enlarged view of a portion of a semiconductor device according to an example embodiment.

Referring to FIG. 4B, a semiconductor device 100B may be the same as or similar to that described with reference to FIGS. 1 to 4A, except that at least a portion of the metal-semiconductor compound layer 120 extends onto the second region R2 of the first source/drain region SD1.

At least a portion of the upper surface and at least a portion of the lower surface of the second region R2 of the first source/drain region SD1 may not be covered by the second insulating pattern 154. Accordingly, one end 120e of the metal-semiconductor compound layer 120 may extend onto the upper surface and the lower surface of the second region R2 of the first source/drain region SD1. The above-mentioned one end 120e of the metal-semiconductor compound layer 120 may be referred to as an extended portion 120e, and a portion of the metal-semiconductor compound layer 120 that is horizontally arranged in a cross-sectional view may be referred to as a horizontal portion 120h.

The thickness of the metal-semiconductor compound layer 120 on the second region R2 of the first source/drain region SD1 and the thickness of the metal-semiconductor compound layer 120 on the first region R1 of the first source/drain region SD1 may be substantially the same as each other.

The metal-semiconductor compound layer 120 and the second region R2 of the first source/drain region SD1 may be discontinuous. For example, based on the side surface of the second insulating pattern 154, the upper surface of the extended portion 120e of the metal-semiconductor compound layer 120 and the upper surface of the first portion P1 of the second region R2 may define a step. In other words, the upper surface of the metal-semiconductor compound layer 120 may not be continuous with the upper surface of the second region R2.

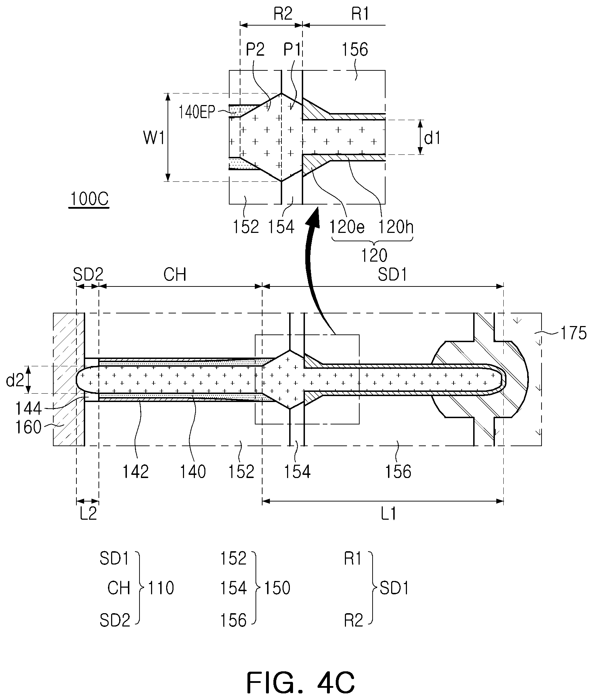

FIG. 4C is an enlarged view of a portion of a semiconductor device according to an example embodiment.

Referring to FIG. 4C, a semiconductor device 100C may be the same as or similar to that described with reference to FIGS. 1 to 4B, except that the first thickness d1 of the first region R1 of the first source/drain region SD1 is smaller than the second thickness d2 of the second source/drain region SD2.

The first thickness d1 of the first region R1 of the first source/drain region SD1 may be smaller than the second thickness d2 of the second source/drain region SD2 and/or the thickness of the channel region CH. The first thickness d1 may have, for example, a thickness of about 10 nm or less. According to an example embodiment, the first thickness d1 may have a range of about 5 nm or more and about 10 nm or less.

The first and second regions R1, R2 of the first source/drain region SD1 may be discontinuous. In other words, with respect to the side surface of the second insulating pattern 154, the upper surface of the first region R1 of the first source/drain region SD1 and the upper surface of the second region R2 of the first source/drain region SD1 may be discontinuous. In other words, the upper surface of the first region R1 of the first source/drain region SD1 and the upper surface of the second region R2 of the first source/drain region SD1 do not form a smooth, flat, continuous surface, instead there is some kind of break between them, for example a step or a gap.

Accordingly, at least a portion of the side surface of the second region R2 of the first source/drain region SD1 may be in contact with the metal-semiconductor compound layer 120. In other words, one end 120e of the metal-semiconductor compound layer 120 may be in contact with the side surface of the second region R2 of the first source/drain region SD1. Similar to those described above with reference to FIG. 4B, the end portion 120e of the metal-semiconductor compound layer 120 may be referred to as an extended portion 120e, and a portion that is horizontally arranged in the cross-sectional view may be referred to as a horizontal portion 120h.

The vertical thickness of the metal-semiconductor compound layer 120 may vary along the X-direction. The vertical thickness of the metal-semiconductor compound layer 120 may gradually become thicker as the metal-semiconductor compound layer 120 approaches a portion adj acent to the second region R2 of the metal-semiconductor compound layer 120. For example, the vertical thickness of the extended portion 120e of the metal-semiconductor compound layer 120 may be thicker than the vertical thickness of the horizontal portion 120h of the metal-semiconductor compound layer 120.

The metal-semiconductor compound layer 120 and the second region R2 of the first source/drain region SD1 may be discontinuous. For example, based on the side surface of the second insulating pattern 154, the upper surface of the extended portion 120e of the metal-semiconductor compound layer 120 and the upper surface of the first portion P1 of the second region R2 may define a step. In other words, the upper surface of the metal-semiconductor compound layer 120 may not be continuous with the upper surface of the second region R2.

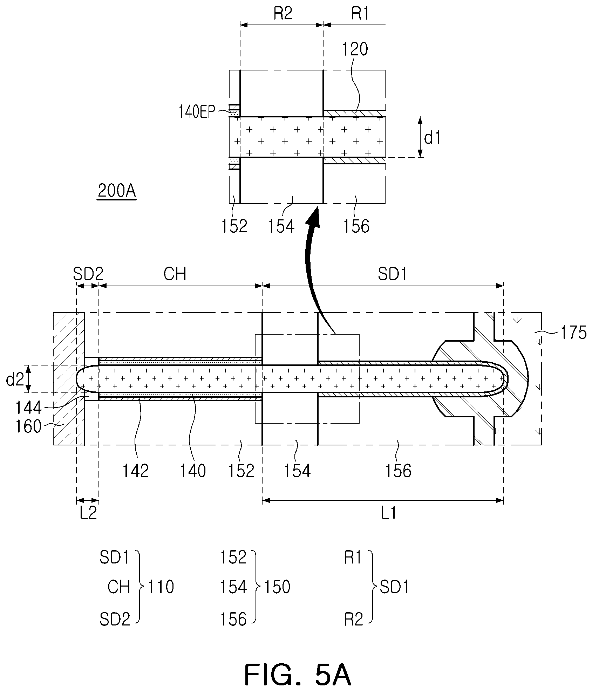

FIG. 5A is a partially enlarged view of a semiconductor device according to an example embodiment.

Referring to FIG. 5A, a semiconductor device 200A may be the same as or similar to that described with reference to FIGS. 1 to 4C, except that the active pattern 110 has a bar shape.

The vertical thickness of the first region R1 and the vertical thickness of the second region R2 may be substantially the same. From another perspective, the maximum thicknesses of the first and second source/drain regions SD1 and SD2 and the channel region CH in the vertical direction may be substantially the same.

The thicknesses of the gate dielectric layer 140 and the gate electrode 142 in the vertical direction may be formed conformally along the X-direction.

The metal-semiconductor compound layer 120 and the second region R2 of the first source/drain region SD1 may be discontinuous. For example, based on the side surface of the second insulating pattern 154, the upper surface of the metal-semiconductor compound layer 120 and the upper surface of the second region R2 may define a step. In other words, the upper surface of the metal-semiconductor compound layer 120 may not be continuous with the upper surface of the second region R2.

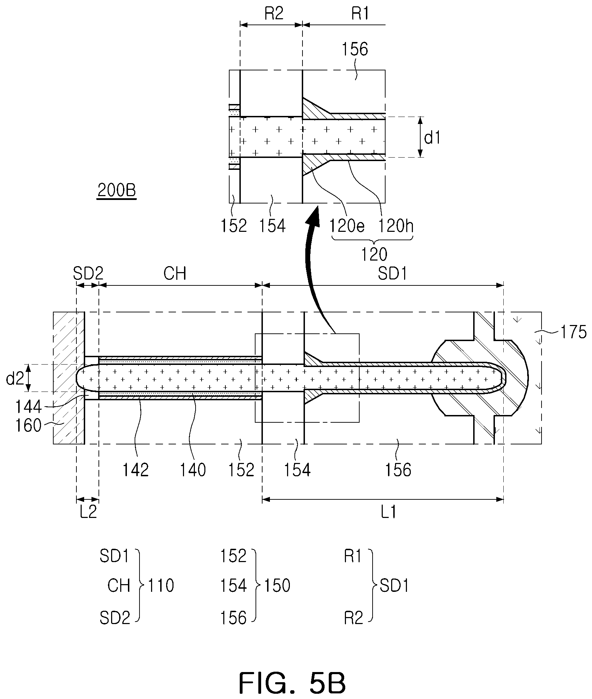

FIG. 5B is an enlarged view of a portion of a semiconductor device according to an example embodiment.

Referring to FIG. 5B, a semiconductor device 200B may be the same as or similar to that described with reference to FIGS. 1 to 5A, except that the first thickness d1 of the first region R1 of the first source/drain region SD1 is smaller than the second thickness d2 of the second source/drain region SD2.

The first thickness d1 of the first region R1 of the first source/drain region SD1 may be smaller than the second thickness d2 of the second source/drain region SD2, the thickness of the channel region CH, and/or the thickness of the second region R2 of the first source/drain region SD1. In this case, the thickness of the channel region CH and the thickness of the second region R2 of the first source/drain region SD1 may be substantially the same as the second thickness d2 of the second source/drain region SD2. The first thickness d1 may have, for example, a thickness of about 10 nm or less. According to an example embodiment, the first thickness d1 may have a range of about 5 nm or more and about 10 nm or less.

The first and second regions R1, R2 of the first source/drain region SD1 may be discontinuous. In other words, with respect to the side surface of the second insulating pattern 154, the upper surface of the first region R1 of the first source/drain region SD1 and the upper surface of the second region R2 of the first source/drain region SD1 may be discontinuous. For example, the upper surface of the first region R1 of the first source/drain region SD1 and the upper surface of the second region R2 of the first source/drain region SD1 may define a step.

Accordingly, at least a part of the side surface of the second region R2 of the first source/drain region SD1 may be in contact with the metal-semiconductor compound layer 120.

The vertical thickness of the metal-semiconductor compound layer 120 may vary along the X-direction. The vertical thickness of the metal-semiconductor compound layer 120 may gradually become thicker in a portion of the metal-semiconductor compound layer 120 adjacent to the second region R2. For example, the vertical thickness of the metal-semiconductor compound layer 120 adjacent to the second region R2 may be thicker than the vertical thickness of the metal-semiconductor compound layer 120 adjacent to the capacitor structure 170.

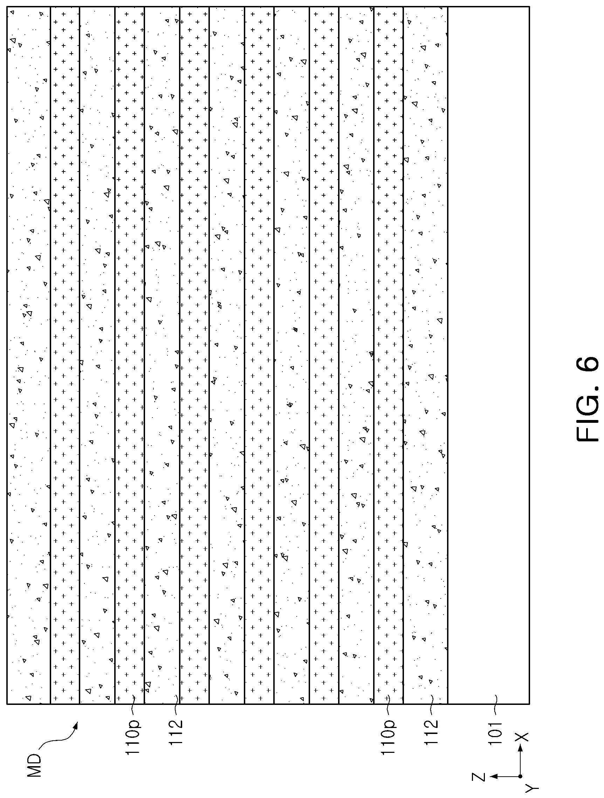

FIGS. 6 to 16 are vertical cross-sectional views illustrated according to a process sequence to describe a manufacturing method of a semiconductor device 100A, 100B according to an example embodiment.

Referring to FIG. 6, a mold structure MD may be formed on a substrate 101.

The mold structure MD may include alternately stacked channel material layers 110p and sacrificial layers 112. The upper surface of the substrate 101 may be in contact with one of the sacrificial layers 112. The sacrificial layers 112 may include a material having an etching selectivity with the channel material layers 110p.

In an example embodiment, the channel material layers 110p may include silicon, and the sacrificial layers 112 may include silicon-germanium, silicon oxide, silicon nitride, silicon carbide, silicon oxynitride, or a combination thereof. In an example embodiment, the channel material layers 110p may include silicon, and the sacrificial layers 112 may include silicon-germanium.

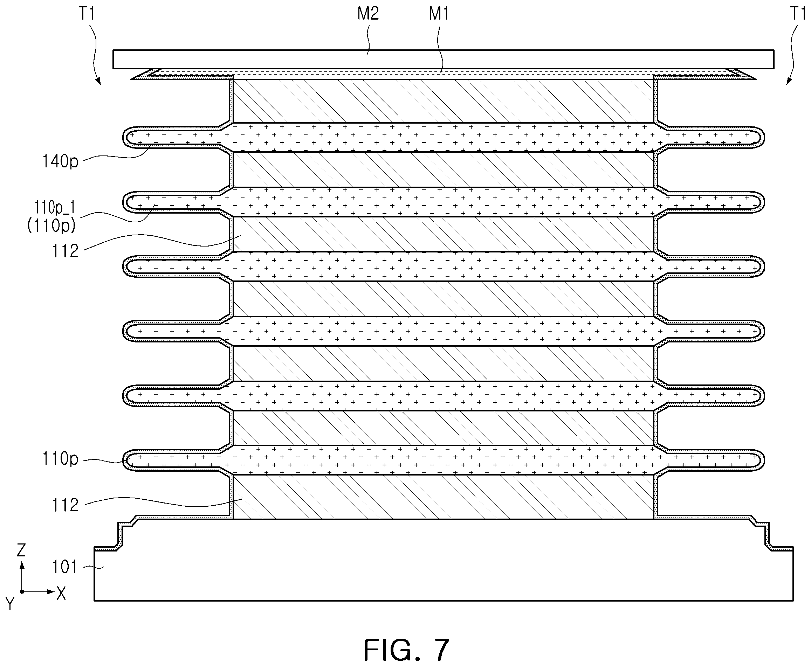

Referring to FIG. 7, first trenches T1 may be formed.

The first trenches T1 may be formed by anisotropically etching the mold structure MD using the first mask layer M1 and the second mask layer M2 as etching masks. The first trenches T1 may extend in the Y-direction. In the above etching process, the upper surface of the substrate 101 may be partially etched.

Afterwards, the sacrificial layers 112 may be partially etched. For example, the sacrificial layers 112 may be partially etched in the horizontal direction by supplying an etchant into the first trenches T1. Accordingly, the channel material layers 110p may have a protrusion 110p_1 protruding from the side surface of the sacrificial layers 112. The protrusion 110p_1 may be formed so that the thickness in the vertical direction becomes thicker as the protrusion 110p_1 approaches the side surface of the sacrificial layers 112. When the thickness of the protrusion 110p_1 is constant along the X-direction, a semiconductor device 200A, 200B may be formed (see FIGS. 5A and 5B).

Subsequently, a liner 140p may be formed in the first trenches T1. The liner 140p may be conformally formed along the surface of the protrusion 110p_1 and the side surface of the sacrificial layers 112. The liner 140p may include at least one of silicon oxide, silicon nitride, or silicon oxynitride. The liner 140p may include a material having an etching selectivity with respect to the channel material layers 110p and the sacrificial layers 112. For example, the liner 140p may include silicon nitride.

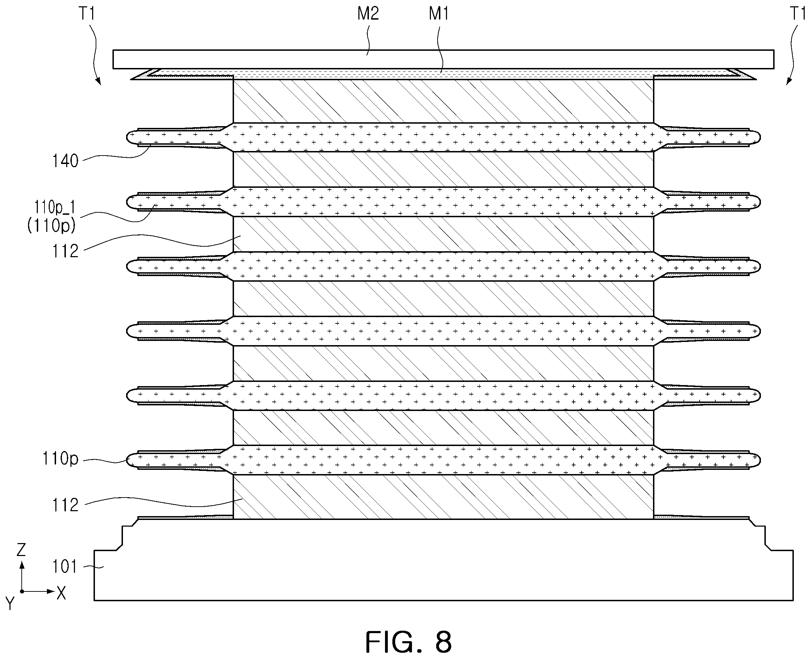

Referring to FIG. 8, a gate dielectric layer 140 may be formed.

The liner 140p may be partially etched, and the gate dielectric layer 140 may be formed. The gate dielectric layer 140 may be formed, for example, by anisotropically etching the liner 140p. The gate dielectric layer 140 may be present on the upper surface and the lower surface of the protrusion 110p_1. Accordingly, one end of the protrusion 110p_1 and the side surface of the sacrificial layers 112 may be exposed. The gate dielectric layer 140 may be formed so that the thickness in the vertical direction increases as the gate dielectric layer 140 approaches the side surface of the sacrificial layers 112 (see FIG. 4A).

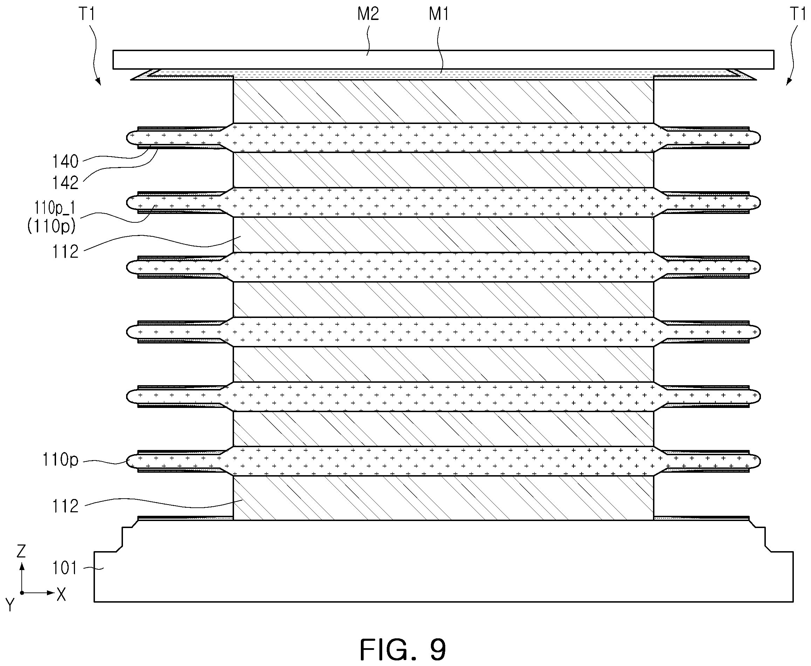

Referring to FIG. 9, gate electrodes 142 may be formed.

After forming a conductive material on the one end of the protrusion 110p_1, the gate dielectric layer 140, and the side surface of the sacrificial layers 112, the conductive material may be etched back to form the gate electrodes 142. The gate electrodes 142 may remain on the upper surface or the lower surface of the gate dielectric layer 140.

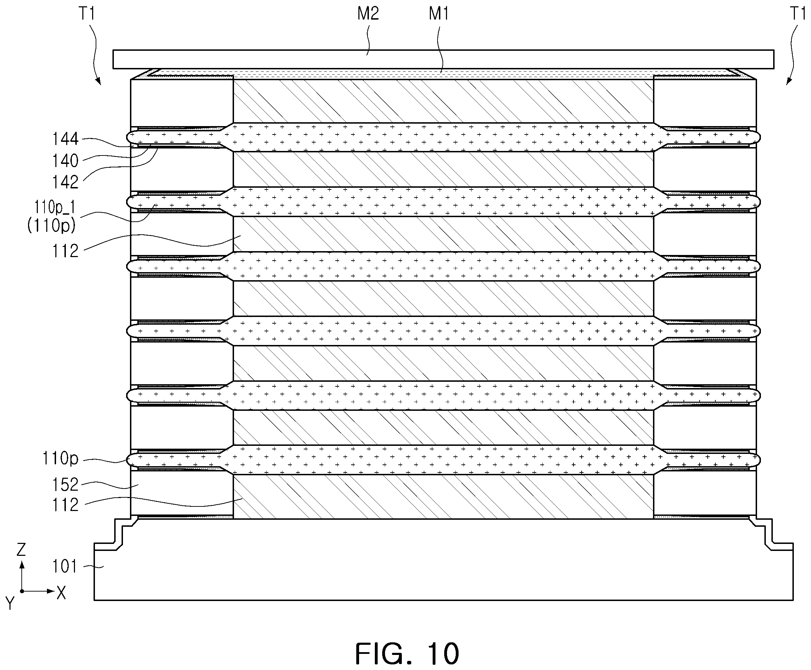

Referring to FIG. 10, a first insulating pattern 152 and a gate capping layer 144 may be formed.

An insulating material may be filled into the first trenches T1 to cover the one end of the protrusion 110p_1, the gate electrodes 142, and the side surfaces of the sacrificial layers 112, and the insulating material may be partially removed to form the first insulating pattern 152. The insulating material may be partially removed, for example, by anisotropic etching. Accordingly, the one end of the protrusion 110p_1, the side surface of the gate dielectric layer 140, and the side surface of the gate electrodes 142 may be exposed. The first insulating pattern 152 may include at least one of silicon oxide, silicon nitride, and silicon oxynitride. The first insulating pattern 152 may include, for example, silicon oxide.

Afterwards, a gate capping layer 144 may be formed. An insulating material may be used to cover the one end of the protrusion 110p_1, the side surface of the gate dielectric layer 140, and the side surface of the gate electrodes 142, and then the one end of the protrusion 110p_1 may be partially removed to expose the gate capping layer 144. The gate capping layer 144 may include at least one of silicon oxide, silicon nitride, or silicon oxynitride. The gate capping layer 144 may include, for example, silicon nitride.

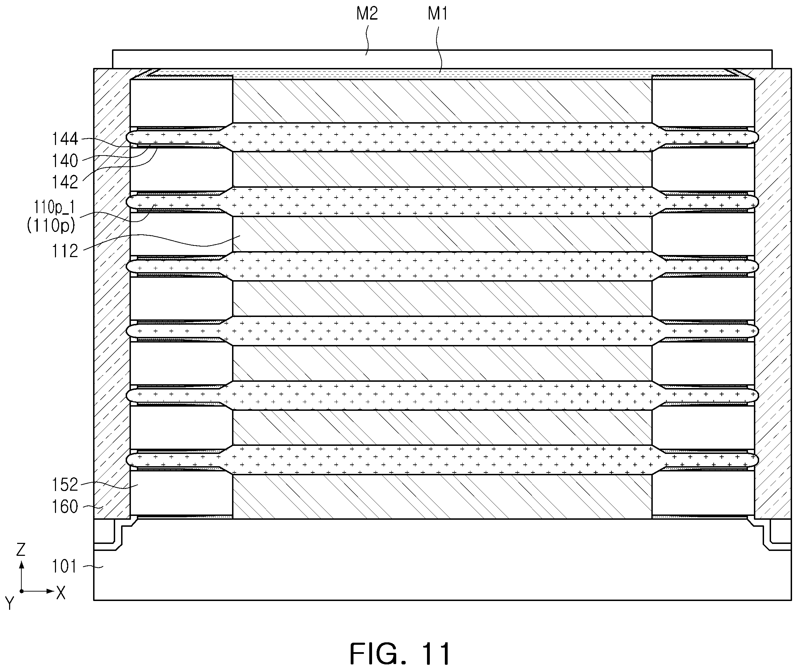

Referring to FIG. 11, bit lines 160 may be formed in the first trenches T1 of FIG. 10.

A conductive material may be formed to contact the channel material layers 110p, and the bit lines 160 may be formed by patterning the conductive material. The bit lines 160 may contact the side surfaces of the gate capping layer 144 and the first insulating pattern 152.

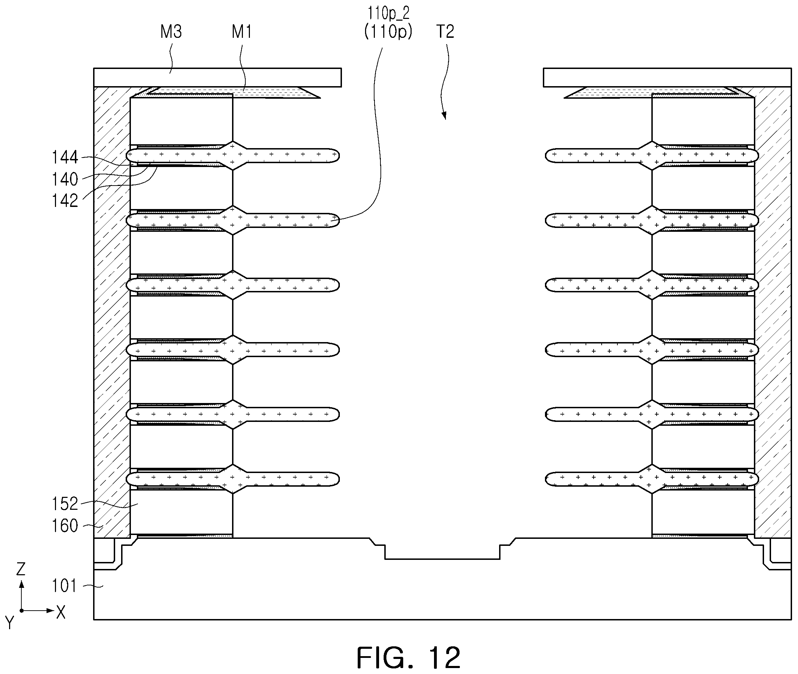

Referring to FIG. 12, second trenches T2 may be formed.

The second trenches T2 may be formed by anisotropically etching the mold structure MD using the first mask layer M1 and the third mask layer M3 as etching masks. The second trenches T2 may extend in the Y-direction. Accordingly, the channel material layers 110p may have a protrusion 110p_2 protruding from the side surfaces of the first insulating patterns 152. In the above etching process, the upper surface of the substrate 101 may be partially etched.

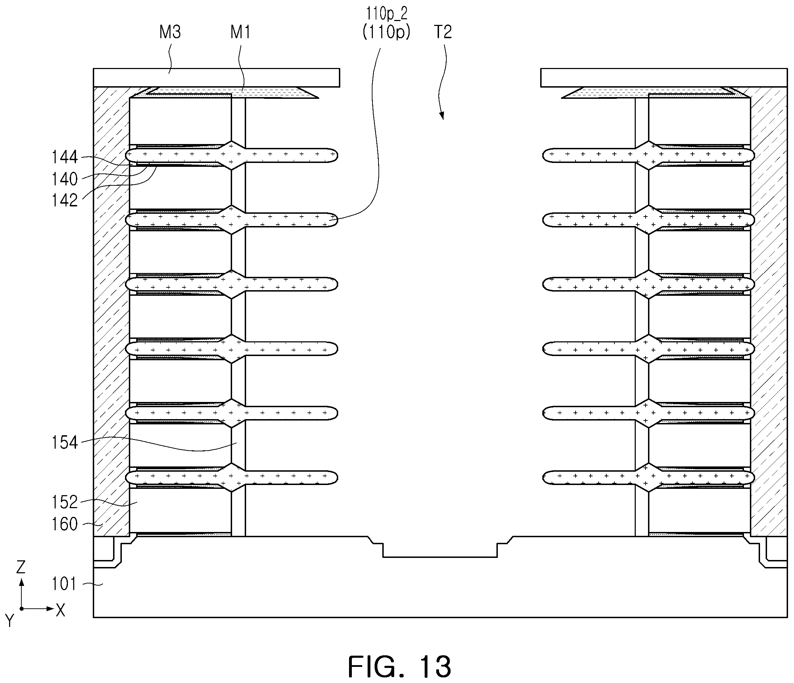

Referring to FIG. 13, a second insulating pattern 154 may be formed.

An insulating material may be filled into the second trenches T2 to cover the first insulating patterns 152 and the protrusions 110p_2, and the insulating material may be partially removed to form a second insulating pattern 154.

If the side surface of the second insulating pattern 154 is on the second region R2 of the active pattern 110, a semiconductor device 100B may be formed (see FIG. 4B).

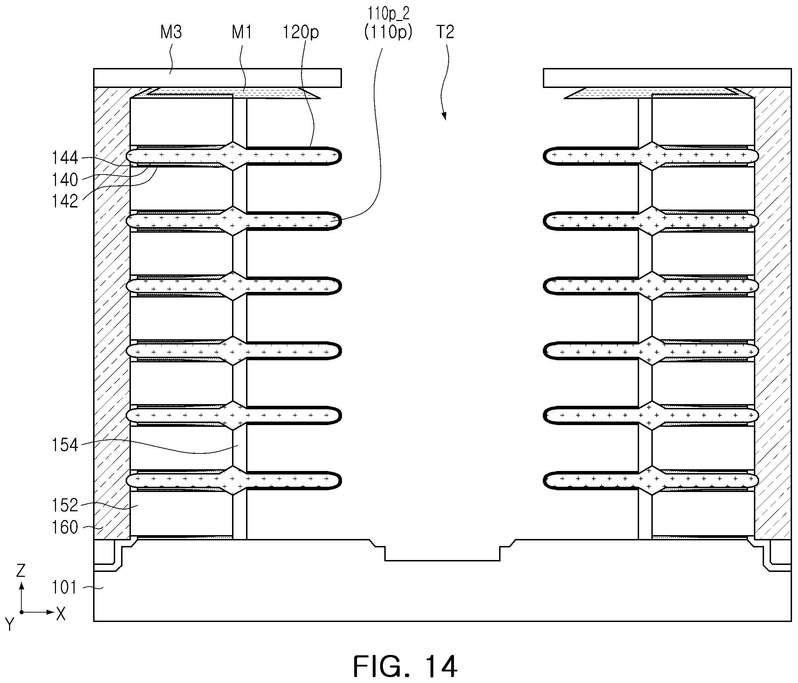

Referring to FIG. 14, a semiconductor pattern 120p or 'buffer layer' may be formed.

The semiconductor pattern 120p may be formed by an epitaxy process. The semiconductor pattern 120p may include epitaxial silicon grown from the surface of the protrusion 110p_2 of the channel material layers 110p. The semiconductor pattern 120p may include a semiconductor doped with an impurity having a first concentration. The impurity may be a group V element, for example, phosphorus P. The first concentration may be about 2 x 10²⁰ cm⁻³ or greater. In an example embodiment, the first concentration may be in a range of about 2 x 10²⁰ cm⁻³ or more to about 2 x 10²¹ cm⁻³. In an example embodiment, the first concentration may be in a range of about 2 x 10²⁰ cm⁻³ or more to about 1 x 10²¹ cm⁻³. The above epitaxy process may be performed at a temperature lower than about 450°C.

Before performing the epitaxy process according to FIG. 14 and forming the second insulating pattern 154 according to FIG. 13, an impurity may be implanted into the protrusion 110p_2 of the channel material layers 110p. The impurity may be injected by vapor phase doping based on a diffusion source made of a gas containing the impurity. The impurity may be a group V element, for example, phosphorus P. The second concentration of the impurity may be less than the first concentration. The second concentration may be, for example, about 2 x 10²⁰ cm⁻³ or less. In an example embodiment, the second concentration may be, for example, in a range of about 1 x 10¹⁹ cm⁻³ or more to about 2 x 10²⁰ cm⁻³. In an example embodiment, the second concentration may be in the range of about 5 x 10¹⁹ cm⁻³ or more to about 2 x 10²⁰ cm⁻³.

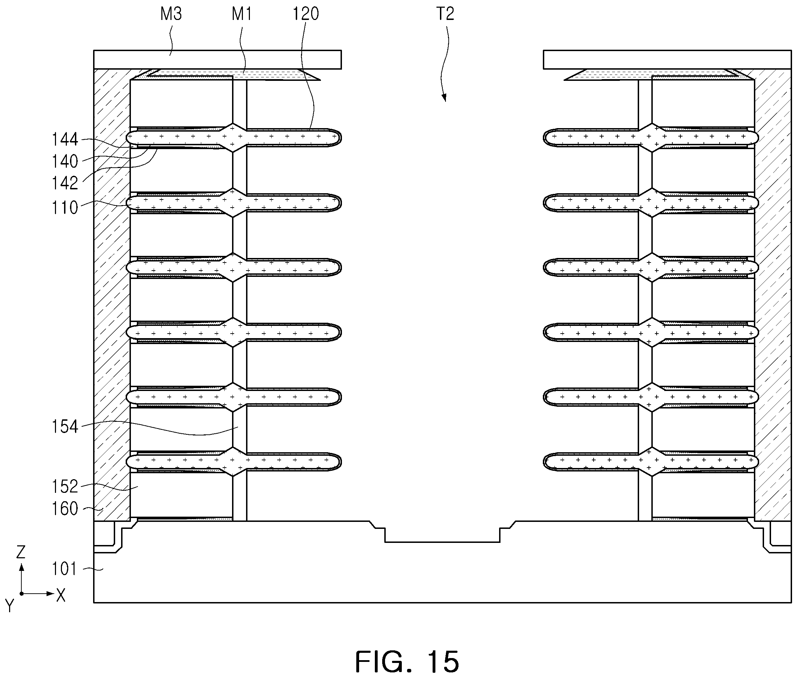

Referring to FIG. 15, a metal-semiconductor compound layer 120 may be formed.

A metal material layer may be formed on the semiconductor pattern 120p of FIG. 14, and the metal-semiconductor compound layer 120 may be formed through an annealing process. The metal material layer may include at least one of molybdenum, cobalt, titanium, nickel, or tungsten. The metal material layer may include titanium, for example. Because the metal-semiconductor compound layer 120 is formed through a silicide process based on the semiconductor pattern 120p, the deterioration of the junction depth of the first source/drain region SD1 of FIG. 4A in the active pattern 110 due to the silicide process may be improved. In other words, the metal material may not penetrate into the active pattern 110 by the semiconductor pattern 120p.

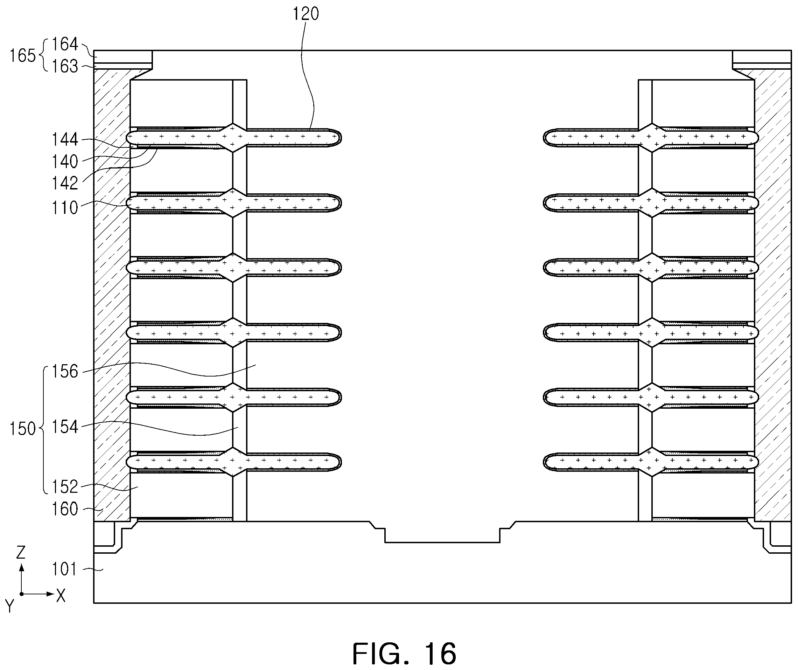

Referring to FIG. 16, a third insulating pattern 156 may be formed.

The first mask layer M1 and the third mask layer M3 of FIG. 15 may be removed, and an insulating material may be filled in the second trench T2 to form the third insulating pattern 156. A contact structure 165 including a first conductive layer 163 and a second conductive layer 164 may be formed on the upper surface of the bit line 160.

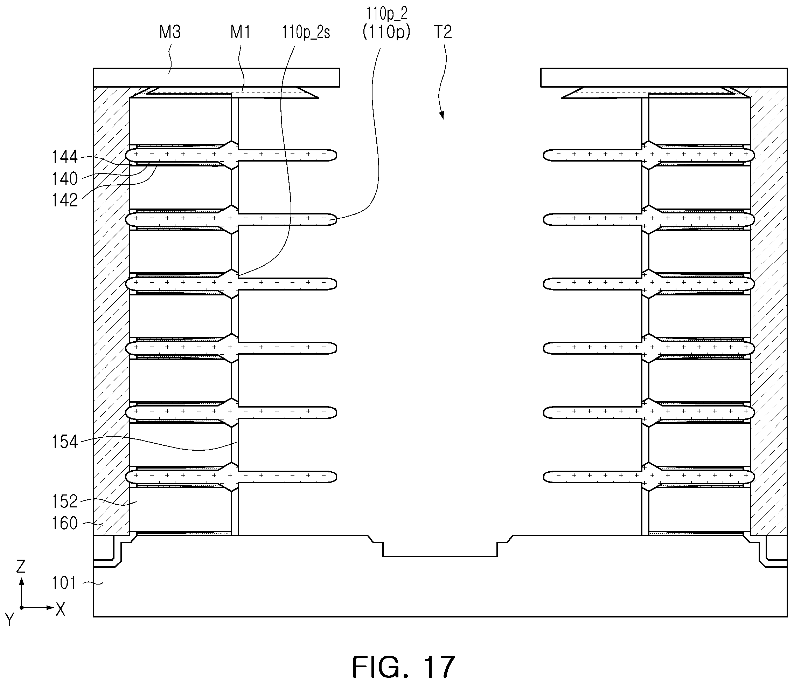

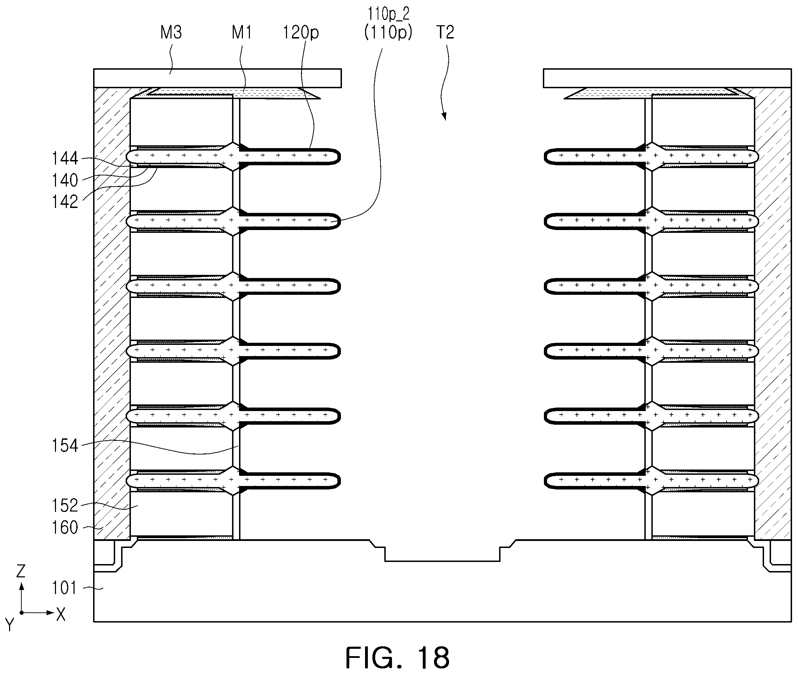

FIGS. 17 and 18 are vertical cross-sectional views illustrating according to a process sequence to describe a method of manufacturing a semiconductor device 100C according to an example embodiment. FIG. 17 may be a process diagram that follows the process described with reference to FIG. 12.

Referring to FIG. 17, a second insulating pattern 154 may be formed, and the protrusion 110p_2 of the channel material layers 110p may be partially removed.

As described above with reference to FIG. 12, a second insulating pattern 154 may be formed. In this process, the side surface of the second insulating pattern 154 may be on the second region R2 of the active pattern 110 (see FIG. 4C).

Thereafter, the protrusion 110p_2 of the channel material layers 110p may be trimmed, and the protrusion 110p_2 may be partially removed. Accordingly, the vertical thickness of the protrusion 110p_2 may be smaller than the vertical thickness of the protrusion 110p_1 (see FIG. 4C). By the above trimming process, a part of the side surface 110p_ 2s of the protrusion 110p_2 may be exposed.

Referring to FIG. 18, a semiconductor pattern 120p may be formed.

As described above with reference to FIG. 14, the semiconductor pattern 120p may be formed by an epitaxy process. The semiconductor pattern 120p may be formed of epitaxial silicon grown from an exposed surface including the side surface 110p_2s of the protrusion 110p_2. Accordingly, the thickness of the semiconductor pattern 120p in the vertical direction may increase as the semiconductor pattern 120p approaches the side surface 110p_2s refer to FIG. 4C.

Thereafter, a semiconductor device 100C may be formed through a process the same as or substantially similar to the process described with reference to FIG. 15 and FIG. 16.

As set forth above, according to some example embodiments, a semiconductor device including a metal-semiconductor compound layer covering a source/drain region of an active pattern is provided.

A semiconductor device according to an example embodiment may be provided by forming a semiconductor pattern on a source/drain region of an active pattern and forming a metal-semiconductor compound layer based on the semiconductor pattern.

According to some example embodiments, by forming a semiconductor pattern including an impurity having a higher concentration than the concentration of an impurity contained in a source/drain region of an active pattern, a delay of signal transmission may be improved (e.g., reduced). In addition, by forming a metal-semiconductor compound layer based on the semiconductor pattern, a deterioration of a junction depth in the active pattern due to a silicide process may be reduced.

While some example embodiments have been illustrated and described above, it will be apparent to those skilled in the art that modifications and variations could be made without departing from the scope of the present inventive concepts as defined by the appended claims.

## Claims

1. A semiconductor device comprising:
an active pattern (110) extending in a first horizontal direction (X), the active pattern (110) comprising a first source/drain region (SD1), a second source/drain region (SD2) and a channel region (CH) between the first and second source/drain regions (SD1, SD2), the first source/drain region (SD1) comprising a first region (R1) and a second region (R2), the second region (R2) being between the channel region (CH) and the first region (R1);
a metal-semiconductor compound layer (120) on the first region (R1) of the first source/drain region (SD1) of the active pattern (110);
a bit line (160) extending in a vertical direction (Z) and contacting the active pattern (110); and
a gate electrode (142) vertically overlapping at least a portion of the channel region (CH) of the active pattern (110), the gate electrode (142) extending in a second horizontal direction (Y), the second horizontal direction (Y) intersecting the first horizontal direction (X),
wherein a length of the first region (R1) in the first horizontal direction (X) is greater than a length (L2) of the second region (R2) in the first horizontal direction (X).

2. The semiconductor device of claim 1, wherein an upper surface of the metal-semiconductor compound layer (120) is discontinuous with an upper surface of the second region (R2) of the first source/drain region (SD1).

3. The semiconductor device of claim 1 or 2, wherein the second region (R2) includes a first portion (P1) adjacent to the first region (R1), the first portion (P1) of the second region (R2) having a thickness in the vertical direction (Z), the thickness of the first portion (P1) of the second region (R2) increasing away from the first region (R1).

4. The semiconductor device of claim 3, wherein at least a portion of the metal-semiconductor compound layer (120) extends to an upper surface and a lower surface of the first portion (P1) of the second region (R2) of the first source/drain region (SD1).

5. The semiconductor device of any one of claims 1 to 4, wherein the second region (R2) includes a second portion (P2) adjacent to the channel region (CH), the second portion (P2) of the second region (R2) having a thickness in the vertical direction (Z), the thickness of the second portion (P2) of the second region (R2) increasing away from the channel region (CH).

6. The semiconductor device of claim 5, further comprising:
a gate dielectric layer (140) between the channel region (CH) of the active pattern (110) and the gate electrode (142),
wherein at least a portion of the gate dielectric layer (140) extends to an upper surface and a lower surface of the second portion (P2) of the second region (R2) of the first source/drain region (SD1).

7. The semiconductor device of claim 6, wherein a thickness of the gate dielectric layer (140) on the second portion (P2) of the second region (R2) of the first source/drain region (SD1) is greater than a thickness of the gate dielectric layer (140) on the channel region (CH).

8. The semiconductor device of any one of claims 1 to 7, wherein an upper surface of the first region (R1) and an upper surface of the second region (R2) are discontinuous from each other.

9. The semiconductor device of any one of claims 1 to 8, wherein at least a portion of the metal-semiconductor compound layer (120) is in contact with a side surface of the second region (R2) of the first source/drain region (SD1).

10. The semiconductor device of any one of claims 1 to 9, wherein a first maximum thickness (W1) of the second region (R2) of the first source/drain region (SD1) in the vertical direction (Z) is greater than a second maximum thickness (d2) of the second source/drain region (SD2) in the vertical direction (Z).

11. The semiconductor device of claim 10, wherein
the first maximum thickness (W1) is in a range of 10 nm to 15 nm, and
the second maximum thickness (d2) is in a range of 5 nm to 10 nm.

12. The semiconductor device of any one of claims 1 to 11, wherein the metal-semiconductor compound layer (120) includes one of molybdenum silicide (MoSi), titanium silicide (TiSi), nickel silicide (NiSi), or tungsten silicide (WSi).

13. The semiconductor device of any one of claims 1 to 12, further comprising:
a first insulating layer (152) in contact with an upper surface and a lower surface of the second portion (P2) of the second region (R2);
a second insulating layer (154) surrounding an upper surface and a lower surface of the first portion (P1) of the second region (R2) and on a side surface of the first insulating layer (152); and
a third insulating layer (156) covering at least a portion of the metal-semiconductor compound layer (120) and on a side surface of the second insulating pattern (154).

14. The semiconductor device of any one of claims 1 to 13, further comprising a capacitor structure (170) electrically connected to the first source/drain region (SD1) by the metal-semiconductor compound layer (120).

15. The semiconductor device of any one of claims 1 to 14, wherein a length (L1) of the first source/drain region (SD1) in the first horizontal direction (X) is greater than a length (L2) of the second source/drain region (SD2) in the first horizontal direction (X).
